# EUROPEAN PATENT APPLICATION

(11) **EP 4 564 438 A1**
(43) Date of publication of application: **04.06.2025**
(21) Application number: 23213159.9
(22) Date of filing: 29.11.2023
(51) Int. Cl.: H01L 31/0224, H01L 31/05

(54) **SOLAR CELL MODULE**

(71) Applicant: "International Solar Energy Research Center Konstanz", ISC Konstanz e.V., 78467 Konstanz (DE)
(72) Inventor: Tune, Daniel, 78224 Singen (DE); Mihailetchi, Valentin, 78464 Konstanz (DE)
(74) Representative: Westphal, Mussgnug & Partner Patentanwälte mbB

(57) **Abstract**

Provided is a solar cell module comprising a string comprising two or more interdigitated back contact solar cells, wherein the interdigitated back contact solar cells are arranged in a shingled manner.

## Description

A solar cell consists of a material or combination of materials that absorbs light and transfers the energy of the light into electrical energy in the form of separated electrical charges. To extract the charges into an external electrical circuit to do work, it is necessary to create positive and negative electrical contacts on the solar cell. Depending on the nature and configuration of the solar cell materials, the generated positive and negative electrical charges need to be collected either from either side of the solar cell, usually the light-facing surface, called the front side or sunny side, and the opposite surface, called the rear side, or from specific regions on the rear side such as in the IBC solar cell design.

The configuration in which the solar cell is contacted on both sides is called both sides contacted and the configuration in which the solar cell is contacted only on the rear side is called back contacted. The electrical contacts are usually a periodic sequence of thin metallic lines called 'fingers', formed by e.g., screen-printed metallic pastes with are later heat-sintered, or evaporation/sputtering of metals through shadow masks. The fingers are usually connected by larger metallic lines called 'busbars', which are used to make electrical contact between solar cells. The metallic contacts themselves and the process of applying the metallic contacts to the solar cell are both called metallization.

A solar cell module consists of a plurality of such solar cells wherein the positive and negative electrical contacts of the solar cells are electrically connected to each other in series, parallel or a combination of series and parallel electrical layouts. An electrically connected plurality of solar cells connected in series is called a (series) solar cell string. A similar plurality of solar cells connected in parallel may be called a (parallel) solar cell string. A solar module usually has two electrical connections, which allows it to be electrically connected in series or parallel or a combination of series and parallel to other solar modules. A plurality of such modules so connected is called a module string.

For a single solar cell i.e., a single light absorbing material or combination of materials, there are simply two electrical contacts and the electrical and physical layout of the assembly into solar cell strings and modules is relatively straightforward. However, it is possible to combine two or more solar cells which absorb different or overlapping regions of the light spectrum in an optical stack such that a portion of the light that enters the stack is absorbed by one solar cell with the remaining light passing through to another solar cell or cells. Such a combination of individual solar cells is called a tandem solar cell and the individual solar cells are called sub-cells. It is customary to refer to the sub-cell through which the light first enters the stack as the top cell and last sub-cell in the stack into which the light enters as the bottom cell.

Although the stack of solar cells is arranged such that the optical path of incoming light passes through all of the sub-cells, there are different ways to extract the electrical charges from a tandem solar cell. One way is to connect the sub-cells in series such that the extraction of charges into an external electrical circuit to do work involves electrically contacting the top of the top cell and the bottom of the bottom cell. This is called a two-terminal (2T) tandem configuration and requires that both sub-cells be both sides contacted. Examples for such configurations can be found in Gee, J. M. A Comparison of Different Module Configurations for Multi-Band-Gap Solar Cells. Solar Cells 1988, 24 (1-2), 147-155.

Another method is to extract the charges from each sub-cell separately. For a tandem solar cell consisting of two sub-cells this entails electrically contacting both contacts of each cell to give a total of two positive and two negative electrical contacts and this is called a four-terminal (4T) tandem configuration.

A hybrid approach is also possible for tandem solar cells consisting of two sub-cells, in which the two sub-cells are monolithically stacked as in the 2T configuration but in which the bottom cell is itself a back contacted solar cell with a third electrical contact placed on the front of the solar cell for interfacing with the rear contact of the top cell. Such a tandem solar cell thus has three electrical contacts and is called a 3T tandem solar cell.

In the 3T configuration, depending on the polarity of the top and bottom contacts of the top cell and on the polarities of the three contacts of the bottom cell, there are a variety of different ways to interconnect the two sub-cells and to extract the generated electrical charges into an external circuit. A taxonomy and nomenclature for the unambiguous classification of the various 3T tandem solar cells is described in Warren, E. L. et al. A Taxonomy for Three-Terminal Tandem Solar Cells. ACS Energy Lett. 2020, 5 (4), 1233-1242.

Following this classification, one embodiment of the invention described in this disclosure is concerned with the types of 3T tandem solar cells referred to as having "IBC contacts".

Commensurate with the variety of different 3T tandem solar cells, there are a variety of ways to interconnect the 3T tandem solar cells into solar cell strings and prominent among these are the so-called "voltage-matched" approaches as described in McMahon, W. E. et al. Homogenous Voltage-Matched Strings Using. IEEE Journal of Photovoltaics 2021, 9. Of these approaches, the *r-type* strings of 2:1 voltage matched sub-cells are the subject of the invention described in this disclosure. It should be noted that the 2:1 voltage match does not have to be exact but needs to be met only approximately. Typically, a variation in operation of 10-20% will be tolerated in the design.

The voltage matching condition necessitates that some of the sub-cells in a 3T tandem module string are either not connected or are operated at a fraction of their normal voltage and this leads to inherent string end losses equivalent to 1-2 cell equivalents of lost power compared to the maximum theoretical sum power of the individual cells in the module string, as described in the above-mentioned publication by McMahon, W. E. et al. Since the string end losses equate to a fixed number of cell equivalents in term of power, the effective loss of power due to the string end losses is greater for module strings consisting of fewer cells than for strings consisting of more cells i.e., the string end losses scale inversely with the number of cells in the string. For an industry-standard 60-cell string, the string end losses equate to approximately 3-5% loss of power compared to the sum of the individual cells' power.

This problem to be solved by this invention is providing an arrangement of solar cells comprising or consisting of an IBC solar cell that allows for improved connections between the solar cells. This problem is solved by a solar cell module with the features of claim 1. Advantageous embodiments of the solar cell module are described in the dependent claims.

More specifically, some embodiments of the invention described in this disclosure significantly reduce the end losses in solar modules based on 3T tandem solar cells, by using cells which are cut into stripes which are a fraction of the full cell width. The string end losses are reduced by the same fraction as the cut cell stripes.

A solar cell module according to this invention comprises one or more solar cell strings, each comprising two or more interdigitated back contact solar cells, wherein the interdigitated back contact solar cells are arranged in a shingled manner, i.e. the cells are cut into thin stripes with the electrical contacts adjacent to opposite edges of the stripes and bonding these stripes to each other with a small overlapping region on the edges of the stripes and with the electrical contact between complementary polarities being made within this overlapping region, similar to shingled roof tiles on buildings. The interdigitated back contact solar cells may be individual interdigitated back contact solar cells or constituents of tandem solar cells, as disclosed in more detail below.

Apart from a simpler manufacturing process, if at least some of the electrical contacts are made within the overlapping region the benefits of the shingling approach include no self-shading of the cell by the busbars, since the busbars are hidden in the overlap region, a reduction of current-induced resistive power losses, since the string current is reduced to the fraction into which the full cells are cut into stripes, and a potentially longer product lifetime due to the reduction of the number of (or even elimination of) ribbon/wire connections and the resulting in-built mechanical strain and microcracks.

According to a preferred embodiment of the invention, a 'reverse metal wrap through' ("reverse-MWT") approach is used to bring the rear contacts of an IBC solar cell to the front of the cell at locations which allow the shingling interconnection approach to be used, so that the interdigitated back contact solar cells are interconnected by reverse-MWT vias.

According to another preferred embodiment of the invention, the interdigitated back contact solar cells constitute parts of 3-terminal tandem solar cells that are formed as a monolithic stack of an interdigitated back contact solar cell as a bottom cell and a higher bandgap solar cell as a top cell, wherein the top cell and the bottom cell are stacked in a reversed connection arrangement, wherein the top and bottom cells are 2:1 voltage matched, and wherein the two or more 3-terminal tandem solar cells are arranged in a shingled manner.

In this configuration, it is especially advantageous if one polarity of the rear side contacts of the interdigitated back contact solar cell of a first 3-terminal tandem solar cell is contacted with the front side metallization of the higher bandgap solar cell of a second 3-terminal tandem solar cell in the string which is overlapped by said first 3-terminal tandem solar cell.

According to further advantageous embodiments of the invention, one (more precisely speaking, the other) polarity of the rear side contacts of the interdigitated back contact solar cell of a first 3-terminal tandem solar cell is contacted with the other polarity of the rear side contacts of the interdigitated back contact solar cell of the 3-terminal tandem solar cell in the string which is overlapped by said first 3-terminal tandem solar cell in the string.

A first way to realize this configuration is that one polarity of the rear side contacts of the interdigitated back contact solar cell of a first 3-terminal tandem solar cell is contacted with the other polarity of the rear side contacts of the interdigitated back contact solar cell of the 3-terminal tandem solar cell in the string which is overlapped by said first 3-terminal tandem solar cell in the string by a reverse-MWT via.

A second way to realize this configuration is that one polarity of the rear side contacts of the interdigitated back contact solar cell of a first tandem solar cell is contacted with the other polarity of the rear side contacts of the interdigitated back contact solar cell of the tandem solar cell in the string which is overlapped by said first tandem solar cell in the string by a ribbon or wire.

A third way to realize this configuration is that one polarity of the rear side contacts of the interdigitated back contact solar cell of a first tandem solar cell is contacted with the other polarity of the rear side contacts of the interdigitated back contact solar cell of the tandem solar cell in the string which is overlapped by said first tandem solar cell in the string by the electrical circuit of a conductive back sheet.

In strings of 3T tandem solar cells, it is necessary to electrically connect the rear contacts of one 3T tandem solar cell to the front contacts of either the next +1 cell in the string or the next +2 cell in the string, depending on whether the strings are r- or s-type, respectively. In some embodiments of the invention described in this disclosure, this is achieved by extending one polarity of the rear side contacts of the IBC bottom cell into the overlap region to be contacted with the front side metallization of the next top cell in the string.

These embodiments of the invention thus allow for all of the required bottom cell to top cell and bottom cell to bottom cell electrical contacts in r-type 3T strings to be created in a single shingling step for the reverse-MWT configuration, or through the use of shingling combined with conductive backsheet or ribbon/wire interconnection.

According to another preferred embodiment of the invention, the layout of busbars and vias of adjacent 3-terminal tandem solar cells in the string is different. This can lead to connection patterns that can be realized more conveniently. Specifically, it is sufficient if there are 3-terminal tandem solar cells with two different layouts of busbars and vias in the string.

During operation, a solar module is subject to a variety of partial shading conditions - situations where a part of the solar module is shaded differently to the rest of the module. Partial shading is less of an issue in large solar farms but is particularly challenging for modules installed on residential or commercial rooftops. When a solar cell in a solar module is shaded compared to the rest of module, a situation arises wherein the shaded cell becomes reverse biased by the rest of the cells in the module. For silicon solar cells this causes heating of the cell which can damage the polymers in which the cell is embedded, or in some cases can damage the cell itself. To minimise this, so-called bypass diodes are incorporated into solar modules with the function that if part of the solar cell string protected by the diode is shaded, the current from the rest of the module can bypass the string with the shaded cell by going instead through the diode. Bypass diode failure and the effects of the resulting reverse bias conditions in the module under shading are another of the major sources of solar module failure or loss of performance over time. For the high bandgap, thin-film solar cells that must form the top cell in a tandem solar cell based on silicon as the bottom cell, exposure to even small reverse bias conditions for short periods of time can cause irreversible and catastrophic damage to the material. The issue is so severe that warrantees offered by major manufacturers of solar modules based on thin-film technologies usually include a clause stating that exposure of their product to particular shading conditions voids the warranty. The invention described in this disclosure allows for electrical layouts that inherently mitigate the effects of partial shading. This is because each 3T cell is connected through the interwoven rear-rear and rear-front circuits not only to the adjacent 3T cell but also to the next +1 3T cell, providing a degree of circuit redundancy.

Next, the invention is explained in more detail using figures that show embodiments of the invention. The figures show:
- Fig. 1:: a simplified rear view of an interdigitated back contact solar cell;
- Fig. 2:: different terminal configurations for tandem cells;
- Fig. 3:: a schematic r-type three-terminal string interconnection layout;
- Fig. 4:: a solar cell arranged for shingling and a solar cell string formed by shingling interconnection;
- Fig. 5:: the contact layouts and connections of a first embodiment of 3T-tandem solar cells having a bottom cell formed by an IBC cell and in which the 3T-tandem solar cells are arranged in an r-type configuration in the solar cell string;
- Fig. 6a,b:: the technical realization of bottom-to-bottom (rear-to-rear)and bottom-to-top (rear-to-front) connections in the embodiment of Fig. 5;
- Fig. 7:: the contact layouts and connections of a second and third embodiment of 3T-tandem solar cells having a bottom cell formed by an IBC cell and in which the 3T-tandem solar cells are arranged in an r-type configuration in the solar cell string;
- Fig. 8:: the technical realization of the respective connections between the bottom cells in the second embodiment; and
- Fig. 9:: the technical realization of the respective connections between the bottom cells in the third embodiment.

For the sake of clarity, not all reference numerals are present in all figures in which they could appear.

In the figures that depict solar cell strings, only the repeating units in the middle of the strings are shown for clarity i.e., without the string end units as described in McMahon, W. E. et al. Homogenous Voltage-Matched Strings Using. IEEE Journal of Photovoltaics 2021, 9.

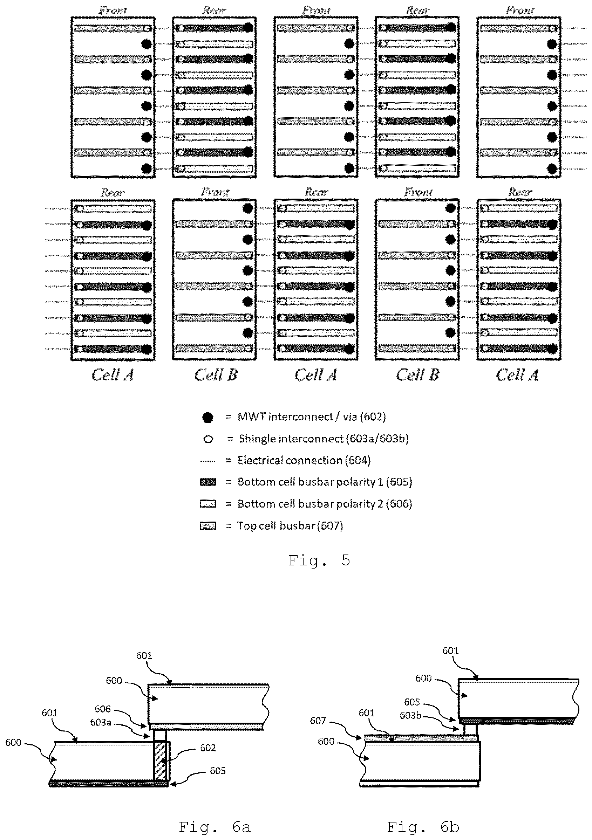

In the figures 6a, 6b, 7, and 9, it is not necessary that the top cell indicated as 601/701 extends into the overlap region as depicted. However, when it does not, a different material must be present in its place to prevent shunting of the top cell by the top contact directly contacting the bottom cell.

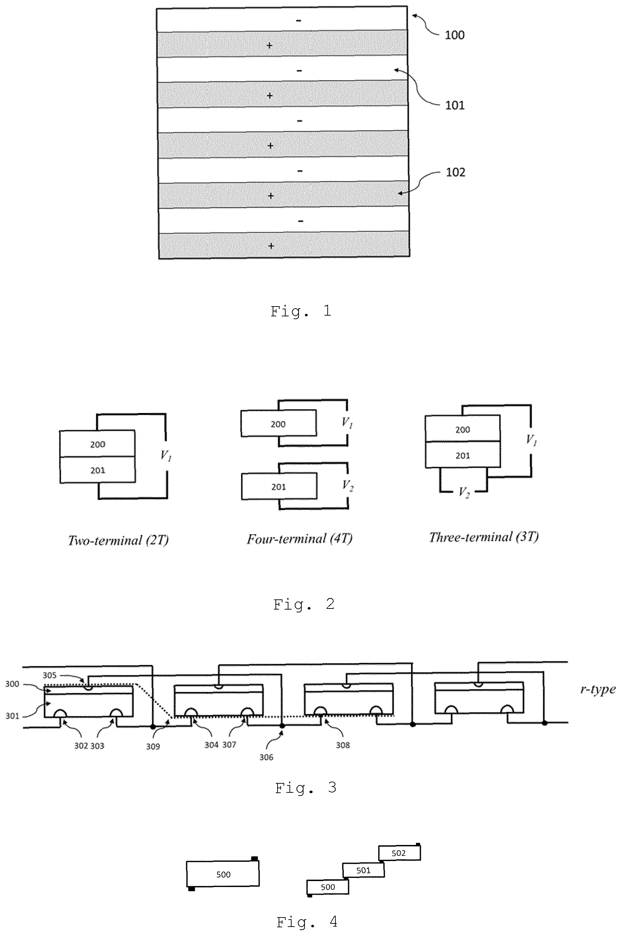

Figure 1 depicts the rear side of an interdigitated back contact (IBC) solar cell 100, showing the periodically alternating polarity regions 101 and 102 that must be contacted to extract the generated electrical charges.

Figure 2 depicts the three types of tandem solar cell interconnection, where V₁ and V₂ indicate the photovoltages of the component circuits and where 200 is the top cell and 201 is the bottom cell.

Figure 3 depicts the electrical circuit that has to be created in order to create a solar cell module based on the r-type variant of the 3T string interconnection using four 3T tandem solar cells as example (end losses not shown). The top cell 300 is monolithically stacked on the bottom cell 301. From the two polarity contacts 302 and 303 of the first bottom cell, one of the polarities 303 connects to the opposite polarity 304 of the next bottom cell in the string. For the r-type variant, the top contact 305 of the top cell 300 is connected to the opposite polarity contact 308 of the third bottom cell in the string (and the same polarity contact 307 of the second cell in the string) at the point 306.

A key insight is that although the connection between 305 and 306 in the circuit diagram depiction appears to go over the top of the second cell in the string, in a real IBC cell the physical busbar depicted as the circuit point 307 actually extends fully across the second cell in the string (as depicted in Figure 1) and is electrically connected to the physical busbar depicted as the circuit point 308 which extends fully across the third cell in the string. It is thus physically and electrically simple to make the 305 to 306 connection as depicted by the dotted line 309, especially when using a shingled arrangement of cells, whose principles are illustrated in Figure 4.

Figure 4 depicts a both-sides-contacted shingle solar cell 500, with black squares indicating busbars and the shingled string interconnection of three cells 500, 501, and 502, wherein the busbars are connected by e.g., solder paste or ECA. It should be noted that in the case of IBC cells, a connection of the contacts, which are exclusively located on the rear side of the cell, is possible e.g. using ribbons or wires, but can preferably be realized by vias that can be obtained using the reverse-MWT technique, in a way that has the same advantages as the busbar-based connection shown in figure 4 for solar cells with contacts on both sides.

Returning to the subject of realizing solar cell strings composed of 3T-tandem solar cells with a bottom cell formed by an IBC cell and in which 3T-tandem solar cells are arranged in an r-type configuration, figures 5 and 6a, 6b show a first embodiment of such a configuration which is realized by connecting 3T-tandem solar cells with two different contact layouts that are called A and B. The respective contact layouts of the A and B cells and the connections that are to be formed are shown in figure 5, whereas figures 6a and 6b show in more detail the technical realization of the rear-rear and front-rear connections, respectively.

In figure 5, five cells connected in a string using the reverse-MWT variant of the invention are displayed. The various components of the figure have the same meaning as in Figure 6. The front and rear sides of two cell layouts A and B required to realise the string interconnection are shown. To correctly show the interconnection, all images are from the perspective of the sunny side of the cell, where the rear side layouts shown are projections through the silicon. As shown, all cell-cell interconnections i.e., both rear-rear and front-rear, exist in the shingle overlap region.

The figures 5, 6a and 6b depict the reverse-MWT variant of the invention in several key aspects.

The rear view of the first bottom IBC cell 600 in a 3T tandem solar cell with layout A shows the alternating polarity busbars 605 and 606, black circles indicate the positions of the reverse-MWT vias 602. White circles indicate both the positions 603a at which the reverse-MWT vias 602 contacting the rear contacts 605 of the bottom cell are electrically connected to the rear contacts 606 of the next bottom cell in the string and 603b at which the rear contacts 605 of the bottom cell are electrically connected to the front contacts 607 of the next top cell in the string within the overlap region of the shingled interconnection. The layout of busbars and vias depicted is intended for r-type strings. The layout is the "A" layout which alternates with the "B" layout in a string of cells, where the positions of the vias and the top cell busbars are different for the A and B cells as seen when comparing the respective cell contact layouts in figure 5.

The front view of the top cell 601 in a 3T tandem solar cell with layout B shows the single polarity busbars 607. Black circles indicate the positions of the reverse-MWT vias 602, white circles indicate the positions 603b at which the front contacts 607 of the top cell are electrically connected to the rear contacts 605 of the next bottom cell in the string within the overlap region of the shingled interconnection. The layout of busbars and vias depicted is intended for r-type strings. The layout is the "B" layout which alternates with the "A" layout in a string of cells, where the positions of the vias and the top cell busbars is different for the A and B as seen when comparing the respective cell contact layouts in figure 5.

The first (leftmost) top front and second bottom rear views of two consecutive 3T tandem solar cells in an r-type string indicate with dotted lines the electrical connections that are made when the two cells are overlapped in the shingle interconnection. To correctly show the interconnection, the depictions of the bottom cells are drawn so as to show the rear side busbars but these are actually on the far side of the cell with respect to the viewers perspective. In the next cells in the string, the positions of the busbars, vias and connection points are alternately mirrored in the vertical plane of the figure so as to logically maintain the same electrical connection as between the first two depicted cells and such that the layouts A and B alternate along the string.

The side view of a shingled interconnection depicting the reverse-MWT variant of the bottom cell to bottom cell electrical connection is shown in figure 6a. The busbar polarity 1 605 of the first bottom cell 600 in the lower tandem cell is connected through a reverse-MWT via 602 and the shingle interconnect (ECA or solder paste) 603a to the busbar polarity 2 606 of the bottom cell 600 in the upper tandem cell. The top cell busbar 607 of the top cell 601 in the lower tandem cell does not take part in this circuit and is omitted from the figure for clarity.

The side view of a shingled interconnection depicting the bottom cell to top cell electrical connection is shown in figure 6b. The top cell busbar 607 of the top cell 601 in the lower tandem cell is connected through a shingle interconnect (ECA or solder paste) 603b to the busbar polarity 1 605 of the bottom cell 600 in the upper tandem cell. The bottom cell to bottom cell connections through the reverse-MWT vias do not take part in this circuit and are omitted for clarity.

These side views of a shingled interconnection thus depict the simultaneous electrical connection of one of the rear side busbars of the IBC bottom cell to a busbar of the next top cell in the string through a shingled interconnection as well as from the other rear side busbar to the rear side busbar of the next bottom cell in the string through a reverse-MWT via and another shingled interconnection in the same shingle overlap region. The string is r-type.

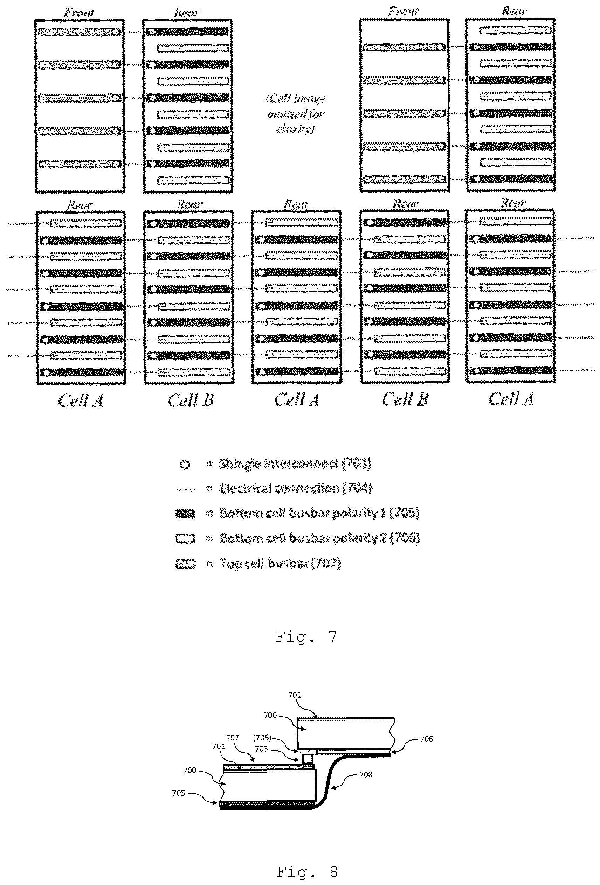

Figures 7 and 8 show a second embodiment of a solar cell string composed of 3T-tandem solar cells with a bottom cell formed by an IBC cell and in which 3T-tandem solar cells are arranged in an r-type configuration, which is realized by connecting 3T-tandem solar cells with two different contact layouts that are called A and B. The respective contact layouts of the A and B cells and the connections that are to be formed are shown in figure 7, whereas figure 8 shows in more detail the technical realization of the respective connections between the bottom cells.

The figures 7 and 8 depict the ribbon/wire variant of the invention in several key aspects.

The rear view of the bottom IBC cell 700 in a 3T tandem solar cell with layout A in figure 7 shows the alternating polarity busbars 705 and 706, white circles indicate the positions 703 at which the rear contacts of the bottom cell are electrically connected to the front of the next top cell in the string within the overlap region of the shingled interconnection. The layout of busbars depicted is intended for r-type strings. The layout is the "A" layout which alternates with the "B" layout in a string of cells, where the positions of the top cell busbars and the layout of the bottom cell busbars is different for A and B, as seen when comparing the respective cell contact layouts in figure 7.

The front view of the top cell 701 in a 3T tandem solar cell with layout B in figure 7 shows the single polarity busbars 707. White circles indicate the positions 703 at which the front contacts of the top cell are electrically connected to the rear of the next bottom cell in the string within the overlap region of the shingled interconnection. The layout of busbars depicted is intended for r-type strings. The layout is the "B" layout which alternates with the "A" layout in a string of cells, where the positions of the top cell busbars is different for the A and B, as seen in figure 7.

The top front and bottom rear views of two consecutive 3T tandem solar cells in an r-type string of figure 7 indicate with dotted lines the electrical connections that are made when the two cells are overlapped in the shingle interconnection. To correctly show the interconnection, the depictions of the bottom cells are drawn so as to show the rear side busbars but these are actually on the far side of the cell with respect to the viewers perspective. In the next cells in the string, the positions of the busbars and connection points are alternately mirrored in the vertical plane of the figure so as to logically maintain the same electrical connection as between first two the depicted cells and such that the layouts A and B alternate along the string.

The side view of a shingled interconnection depicting the ribbon/wire variant of the bottom cell to bottom cell electrical connection is shown in figure 8. The busbar polarity 1 705 of the bottom cell 700 in the lower tandem cell is connected through a ribbon/wire (soldered or bonded with ECA or solder paste to the cell's busbar) 708 to the busbar polarity 2 706 of the bottom cell 700 in the upper tandem cell. As in the first embodiment of the invention, the top cell busbar 707 of the top cell 701 in the lower tandem cell is connected through a shingle interconnect 703 to the busbar polarity 1 705 of the bottom cell 700 in the upper tandem cell.

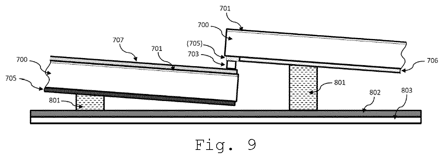

Figure 9 shows a third embodiment of a solar cell string composed of 3T-tandem solar cells with a bottom cell formed by an IBC cell and in which 3T-tandem solar cells are arranged in an r-type configuration which is realized by connecting 3T-tandem solar cells with two different contact layouts that are called A and B. The respective contact layouts of the A and B cells are the same as shown in figure 7. Figure 9 shows an alternative technical realization of the connections between the respective bottom cells. Accordingly, the discussion of the third embodiment relates to figures 7 and 9.

The figures 7 and 9 depict the conductive backsheet variant of the invention in several key aspects.

The rear view of the bottom IBC cell 700 in a 3T tandem solar cell with layout A in figure 7 shows the alternating polarity busbars 705 and 706, white circles indicate the positions 703 at which the rear contacts of the bottom cell are electrically connected to the front of the next top cell in the string within the overlap region of the shingled interconnection. The layout of busbars depicted is intended for r-type strings. The layout is the "A" layout which alternates with the "B" layout in a string of cells, where the positions of the top cell busbars and the layout of the bottom cell busbars is different for A and B, as seen when comparing the respective cell contact layouts in figure 7.

The front view of the top cell 701 in a 3T tandem solar cell with layout B in figure 7 shows the single polarity busbars 707. White circles indicate the positions 703 at which the front contacts of the top cell are electrically connected to the rear of the next bottom cell in the string within the overlap region of the shingled interconnection. The layout of busbars depicted is intended for r-type strings. The layout is the "B" layout which alternates with the "A" layout in a string of cells, where the positions of the top cell busbars is different for the A and B, as seen in figure 7.

The top front and bottom rear views of two consecutive 3T tandem solar cells in an r-type string of figure 7 indicate with dotted lines the electrical connections that are made when the two cells are overlapped in the shingle interconnection. To correctly show the interconnection, the depictions of the bottom cells are drawn so as to show the rear side busbars but these are actually on the far side of the cell with respect to the viewers perspective. In the next cells in the string, the positions of the busbars and connection points are alternately mirrored in the vertical plane of the figure so as to logically maintain the same electrical connection as between the first two depicted cells and such that the layouts A and B alternate along the string.

The side view of figure 9 shows a shingled interconnection depicting the conductive backsheet variant of the bottom cell to bottom cell electrical connection. The busbar polarity 1 705 of the bottom cell 700 in the lower tandem cell is connected through a conductive adhesive or solder paste or other conductive bond 801 to the conductive circuit 802 on a nonconductive support 803 and thus through another conductive bond 801 to the busbar polarity 2 706 of the bottom cell 700 in the upper tandem cell. As in the other variants of the invention, the top cell busbar 707 of the top cell 701 in the lower tandem cell is connected through a shingle interconnect 703 to the busbar polarity 1 705 of the bottom cell 700 in the upper tandem cell.

### Reference numerals

- 100: interdigitated back contact (IBC) solar cell
- 101,102: polarity region
- 200: top cell
- 201: bottom cell
- 300: top cell
- 301: bottom cell
- 302,303: polarity contact
- 304: opposite polarity contact (of next bottom cell)
- 305: top contact
- 306: point
- 307: same polarity contact (of second cell)
- 308: opposite polarity contact (of third bottom cell)
- 309: dotted line
- 500: solar cell
- 501: solar cell
- 502: solar cell
- 600: first bottom IBC cell
- 605,606: alternating polarity busbar rear contacts
- 602: reverse-MWT via
- 603a,603b: contact position
- 607: single polarity busbar front contact
- 700: bottom IBC solar cell
- 703: contact position
- 705,706: alternating polarity busbars
- 707: single polarity busbar front contact
- 708: ribbon/wire
- A,B: cell layout
- V₁,V₂: photo voltage

## Claims

1. A solar cell module comprising a string comprising two or more interdigitated back contact solar cells, wherein the interdigitated back contact solar cells are arranged in a shingled manner.

2. The solar cell module of claim 1,
wherein electrical contacts are made within the overlapping region.

3. The solar cell module of claim 1 or 2,
wherein the interdigitated back contact solar cells constitute parts of 3-terminal tandem solar cells that are formed as a monolithic stack of an interdigitated back contact solar cell as a bottom cell and a higher bandgap solar cell as a top cell,
wherein the top cell and the bottom cell are stacked in a reversed connection arrangement,
wherein the top cell and the bottom cell are 2:1 voltage matched, and
wherein the two or more 3-terminal tandem solar cells are arranged in a shingled manner.

4. The solar cell module of claim 3,
wherein one polarity of the rear side contacts of the interdigitated back contact solar cell of a first 3-terminal tandem solar cell is contacted with the front side metallization of the higher bandgap solar cell of a second 3-terminal tandem solar cell in the string which is overlapped by said first 3-terminal tandem solar cell.

5. The solar cell module of claim 3 or 4,
wherein one polarity of the rear side contacts of the interdigitated back contact solar cell of a first 3-terminal tandem solar cell is contacted with the other polarity of the rear side contacts of the interdigitated back contact solar cell of the 3-terminal tandem solar cell in the string which is overlapped by said first 3-terminal tandem solar cell in the string.

6. The solar cell module of claim 5,
wherein one polarity of the rear side contacts of the interdigitated back contact solar cell of a first 3-terminal tandem solar cell is contacted with the other polarity of the rear side contacts of the interdigitated back contact solar cell of the next 3-terminal tandem solar cell in the string which is overlapped by said first 3-terminal tandem solar cell in the string by a reverse metal wrap through via.

7. The solar cell module of claim 5,
wherein one polarity of the rear side contacts of the interdigitated back contact solar cell of a first tandem solar cell is contacted with the other polarity of the rear side contacts of the interdigitated back contact solar cell of the next tandem solar cell in the string which is overlapped by said first tandem solar cell in the string by a ribbon or wire.

8. The solar cell module of claim 5,
wherein one polarity of the rear side contacts of the interdigitated back contact solar cell of a first tandem solar cell is contacted with the other polarity of the rear side contacts of the interdigitated back contact solar cell of the next tandem solar cell in the string which is overlapped by said first tandem solar cell in the string by a conductive back sheet.

9. The solar cell module of one of claims 3 to 8,
wherein the layout of busbars of adjacent 3-terminal tandem solar cells in the string is different.

10. The solar cell module of claim 9,
wherein there are 3-terminal tandem solar cells with two different layouts of busbars in the string.

11. The solar cell module of claim 1 or 2,
wherein the interdigitated back contact solar cells are interconnected using reverse metal wrap through vias.
